# EUROPEAN PATENT SPECIFICATION

(11) **EP 3 202 750 B1**
(45) Date of publication and mention of the grant of the patent: **13.05.2020**
(21) Application number: 15847784.4
(22) Date of filing: 29.09.2015
(51) Int. Cl.: C04B 35/58, C04B 35/581, B23B 27/14, C04B 35/626, C23C 14/06, C23C 14/24, C23C 14/32, C04B 35/5831, C04B 35/645

(54) **SINTERED MATERIAL, CUTTING TOOL USING SINTERED MATERIAL, AND METHOD OF PRODUCING SINTERED MATERIAL**
SINTERMATERIAL, DAS GESINTERTE MATERIAL VERWENDENDES SCHNEIDWERKZEUG UND VERFAHREN ZUR HERSTELLUNG DES GESINTERTEN MATERIALS
MATÉRIAL FRITTÉ, OUTIL DE COUPE UTILISANT LE MATÉRIAL FRITTÉ ET PROCEDÉ DE FABRICATION DU MATÉRIAL FRITTÉ

(30) Priority: 03.10.2014 JP 2014204706
(43) Date of publication of application: 09.08.2017
(73) Proprietor: Sumitomo Electric Industries, Ltd., Osaka-shi, Osaka 541-0041 (JP)
(72) Inventor: ISHII, Akito, Itami-shi Hyogo 664-0016 (JP); KUKINO, Satoru, Itami-shi Hyogo 664-0016 (JP); HARADA, Takashi, Itami-shi Hyogo 664-0016 (JP)
(74) Representative: Boult Wade Tennant LLP
(86) International application number: PCT/JP2015/077494
(87) International publication number: WO 2016/052497

(56) References cited:
- JP-A- 2014 105 131
- JP-A- 2014 105 131
- JP-A- 2014 185 054
- JP-A- 2014 185 054
- US-A1- 2013 309 468
- KANGPEI ZHENG ET AL: "Investigation on microstructure and properties of CrAlN/AlON nanomultilayers", APPLIED SURFACE SCIENCE, ELSEVIER, AMSTERDAM, NL, vol. 257, no. 22, 13 June 2011 (2011-06-13), pages 9583-9586, XP028256538, ISSN: 0169-4332, DOI: 10.1016/J.APSUSC.2011.06.069 [retrieved on 2011-06-21]

## Description

### TECHNICAL FIELD

The present invention relates to a sintered material, a cutting tool using the sintered material, and a method of producing the sintered material.

### BACKGROUND ART

As a material of a cutting tool used for cutting or the like, an aluminum oxide (Al₂O₃) sintered material has been known. Such an aluminum oxide sintered material is excellent in that it has low reactivity with an iron-based workpiece and can be produced inexpensively; however, the aluminum oxide sintered material tends to have a low toughness. Accordingly, the aluminum oxide sintered material tends to be likely damaged when used as a cutting tool. Furthermore, since reactivity between aluminum oxide and a metallic compound to serve as a binder is low, it is difficult to employ, as the binder, a nitride, carbonitride, or the like of each of metals of group 4A, group 5A, and group 6A in the periodic table.

To address this, as a ceramic sintered material having high hardness and toughness, Patent Document 1 (Japanese Patent Laying-Open No. 2013-216517) discloses a ceramic sintered material including: a cubic aluminum nitride; and at least one metallic compound selected from a group consisting of nitrides, carbides, oxides, and borides of metals of group 4A, group 5A, and group 6A in the periodic table as well as solid solutions thereof. JP2014105131A relates to a sintered body and method of manufacturing the sintered body. JP2014185054 A relates to a ceramic crystal grain, a ceramic sintered compact and a method for producing them.

### CITATION LIST

### PATENT DOCUMENT

PTD 1: Japanese Patent Laying-Open No. 2013-216517

### SUMMARY OF INVENTION

### TECHNICAL PROBLEM

However, the technique of Patent Document 1 employs a cubic aluminum nitride having a low heat resistance. Accordingly, under a high speed cutting condition in the case of cutting a centrifugal cast iron or the like, the cubic aluminum nitride in the sintered material is converted into a hexagonal aluminum nitride having a low hardness. Thus, wear resistance of the sintered material is decreased under the high speed cutting condition, disadvantageously.

In view of this, it is an object to provide: a sintered material having an excellent wear resistance even under a high speed cutting condition; a tool using the sintered material; and a method of producing the sintered material.

### SOLUTION TO PROBLEM

A sintered material according to one embodiment of the present invention is a sintered material according to claim 1.

A cutting tool according to one embodiment of the present invention is a cutting tool comprising the sintered material described above.

A method of producing a sintered material according to one embodiment of the present invention is a method according to claim 5.

A method of producing a sintered material according to one embodiment of the present invention is a method according to claim 6.

### ADVANTAGEOUS EFFECTS OF INVENTION

According to the above embodiment, there can be provided: a sintered material having an excellent wear resistance even under a high speed cutting condition; a tool using the sintered material; and a method of producing the sintered material.

### BRIEF DESCRIPTION OF DRAWINGS

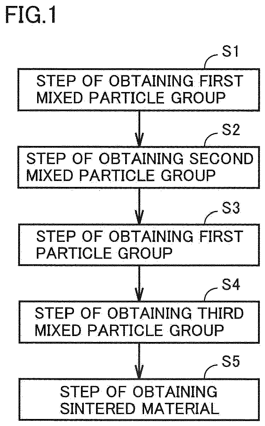

Fig. 1 is a flowchart showing a method of producing a sintered material according to one embodiment of the present invention.

### DESCRIPTION OF EMBODIMENTS

### [Description of Embodiment of the Present Invention]

First, embodiments of the present invention are listed and described.
(1) A sintered material according to one embodiment of the present invention is a sintered material according to claim 1.
   In the particle (hereinafter, also referred to as "cubic AlCrN" or "cAlCrN") represented by the formula (1), chromium is dissolved in the solid state in cubic aluminum nitride (hereinafter, also referred to as "cubic AlN" or "cAlN") having a low heat resistance. Heat resistance is excellent in this particle. Therefore, the sintered material using this particle can have an excellent wear resistance even under a high speed cutting condition.
(2) x satisfies 0.3 ≤ x ≤ 0.7. According to this configuration, the wear resistance of the sintered material is further improved.
(3) Preferably, the sintered material includes not less than 0.5 volume % and not more than 90 volume % of the second particle group, and the first compound includes at least one selected from a group consisting of Al₂O₃ and AlON. By using, as the first compound, the above-described range of amount of Al₂O₃ or AlON, sinterability of the sintered material is improved, thus resulting in further improved wear resistance of the sintered material.
(4) The sintered material further includes a third particle group including a cubic boron nitride. The cubic boron nitride is a hard particle having more excellent toughness and strength than those of the particle having the cubic rock-salt structure represented by the formula (1). Hence, when the sintered material includes such particles, the toughness of the sintered material is improved, thus resulting in improved chipping resistance.
(5) Preferably, the sintered material includes not less than 20 volume % and not more than 70 volume % of the third particle group. Accordingly, the chipping resistance of the sintered material is further improved.
(6) A tool according to one embodiment of the present invention is a cutting tool comprising the sintered material recited in any one of (1) to (5). Since the sintered material is excellent in wear resistance, the tool using this sintered material is also excellent in wear resistance. Hence, the tool according to one embodiment of the present invention can have a longer life than that of the conventional tool.
(7) A method of producing a sintered material according to one embodiment of the present invention is a method according to claim 5.
   According to the method of producing the sintered material, the sintered material recited in any one of (1) to (5) can be obtained.
(8) A method of producing a sintered material according to one embodiment of the present invention is a method according to claim 6.

According to the method of producing the sintered material, the sintered material recited in any one of (1) to (5) can be obtained.

### [Details of Embodiment of the Present Invention]

With reference to figures, the following describes specific examples of a sintered material, a tool, and a method of producing the sintered material according to an embodiment of the present invention. It should be noted that the present invention is defined by the terms of the claims, rather than these examples.

When an atomic ratio is not particularly defined in a chemical formula described in the present specification, respective elements are not necessarily contained at an equal atomic ratio. It is intended to include all the conventionally known atomic ratios.

In the present specification, the term "average particle size" refers to a value measured with a particle size distribution measurement device such as Microtrac.

### <First Embodiment>

A sintered material according to a first embodiment is a sintered material according to claim 1.

The cubic rock-salt crystal structure, which is a crystal structure representative of a rock salt (sodium chloride), is such a structure that two different types of face centered cubic lattices are combined to be displaced from each other in the direction of ridge of a unit cubic lattice by half the ridge length. The particle (cAlCrN) having the cubic rock-salt structure represented by the above formula (1) has a structure having chromium dissolved in the solid state in the crystal structure of cubic aluminum nitride (cAIN). Accordingly, cAlCrN has a heat-resistant temperature higher than that of cAlN. Hence, the sintered material including cAlCrN can have an excellent wear resistance in high speed cutting.

In the above formula (1), x satisfies 0.3 ≤ x ≤ 0.7, and x preferably satisfies 0.4 ≤ x ≤ 0.6. If x is less than 0.2, the sintered material cannot exhibit excellent wear resistance in high speed cutting. This is presumably because the heat resistance of cAlCrN is not sufficiently improved if x is less than 0.3. On the other hand, if x is more than 0.7, the sintered material cannot exhibit excellent wear resistance in high speed cutting. This is presumably due to the following reason: if x is more than 0.7, the hardness of cAlCrN is decreased, so that the hardness of the sintered material is also decreased.

The sintered material according to the first embodiment preferably includes not less than 20 volume % and not more than 99.5 volume % of the first particle group, more preferably includes not less than 35 volume % and not more than 99.5 volume % of the first particle group, and further preferably includes not less than 40 volume % and not more than 80 volume % of the first particle group. When the sintered material includes not less than 20 volume % of the first particle group, the sintered material can have an excellent wear resistance in high speed cutting.

The sintered material according to the first embodiment includes a second particle group including a particle of at least one first compound selected from a group consisting of oxide and oxynitride of aluminum. The second particle group in the sintered material exists in an interface between adjacent hard particles, and serves as a binder phase. Since the binder phase can bind the hard particles to each other strongly, the sintered material can have a more excellent wear resistance.

Examples of the first compound included in the second particle group include aluminum oxide (Al₂O₃), zirconium oxide (ZrO₂) (reference example), yttrium oxide (Y₂O₃) (reference example), magnesium oxide (MgO) (reference example), hafnium oxide (HfO₂) (reference example), and the like. Among these, the use of aluminum oxide (Al₂O₃), yttrium oxide (Y₂O₃) (reference example), magnesium oxide (MgO) (reference example), and hafnium oxide (HfO₂) (reference example) leads to significant improvement of the wear resistance of the sintered material.

The sintered material according to the first embodiment preferably includes not less than 0.5 volume % and not more than 90 volume % of the second particle group, and more preferably includes not less than 10 volume % and not more than 50 volume % of the second particle group. When the sintered material includes not less than 0.5 volume % and not more than 90 volume % of the second particle group, the wear resistance and chipping resistance of the sintered material are improved further. Moreover, when the second particle group includes Al₂O₃ and ZrO₂ (reference example), the chipping resistance of the sintered material is significantly improved. This is presumably because Al₂O₃ is dispersion-strengthened by ZrO₂ to provide strong toughness.

The sintered material according to the first embodiment further includes a third particle group including a cubic boron nitride. The cubic boron nitride is a hard particle having more excellent toughness and strength than those of cAlCrN. Hence, when the sintered material includes such particles, the toughness of the sintered material is improved, thus resulting in improved chipping resistance. Particularly, when the third particle group includes cubic boron nitride, the chipping resistance of the sintered material is significantly improved. This is presumably because boron and cAlCrN are bonded to each other strongly.

The sintered material further preferably includes not less than 20 volume % and not more than 70 volume % of the third particle group. When the sintered material includes not less than 20 volume % of the third particle group, the chipping resistance of the sintered material is significantly improved. On the other hand, if the amount of the third particle group in the sintered material is more than 70 volume %, the wear resistance is decreased.

### <Second Embodiment>

A tool according to a second embodiment is a tool using the sintered material according to the first embodiment. Since the sintered material of the first embodiment is excellent in wear resistance in high speed cutting as described above, the tool using this sintered material is also excellent in wear resistance.

Examples of the cutting tool according to the second embodiment include a drill, an end mill, an indexable cutting insert for milling, an indexable cutting insert for turning, a metal saw, a gear cutting tool, a reamer, or a tap. Moreover, the cutting tool may be entirely or partially (for example, an edge portion) composed of the above sintered material.

When the cutting tool is entirely composed of the above sintered material, the cutting tool can be produced by processing the sintered material into a desired shape. The sintered material can be processed by a laser, for example. On the other hand, when the cutting tool is partially composed of the above sintered material, the cutting tool can be produced by joining the sintered material to a desired position of a base body included in the tool. It should be noted that a method of joining the sintered material is not particularly limited; however, in order to suppress the sintered material from being separated from the base body, it is preferable to provide a joining layer between the base body and the sintered material to strongly couple the base body and the sintered material to each other.

### <Third Embodiment>

The following describes a method of producing the sintered material according to a third embodiment with reference to Fig. 1.

The method of producing the sintered material recited in the first embodiment includes: a step (indicated as S1 in Fig. 1; hereinafter, also referred to as "the step of obtaining the first mixed particle group") of obtaining a first mixed particle group including a hexagonal AlN particle and a hexagonal Cr₂N particle; a step (indicated as S2 in Fig. 1; hereinafter, referred to as "the step of obtaining the second mixed particle group") of obtaining a second mixed particle group including a cubic CrN particle by thermally treating the first mixed particle group; a step (indicated as S3 in Fig. 1; hereinafter, also referred to as "the step of obtaining the first particle group") of obtaining, by treating the second mixed particle group through an isostatic synthesis method or an impulsive compression method, a first particle group including a particle having a cubic rock-salt structure represented by Al₍₁₋ₓ₎CrₓN (formula (1)) (where x satisfies 0.3 ≤ x ≤ 0.7); a step (indicated as S4 in Fig. 1; hereinafter, also referred to as "the step of obtaining the third mixed particle group") of obtaining a third mixed particle group by mixing the first particle group with a second particle group including a particle of at least one first compound selected from a group consisting of oxide and oxynitride of aluminum; and a step (indicated as S5 in Fig. 1; hereinafter, also referred to as "the step of obtaining the sintered material") of obtaining a sintered material by sintering the third mixed particle group.

### (Step of Obtaining First Mixed Particle Group)

With reference to Fig. 1, in the step (S1) of obtaining the first mixed particle group, the first mixed particle group is obtained which includes a hexagonal AlN (hereinafter, also referred to as "hAIN") particle and a hexagonal Cr₂N (hereinafter, also referred to as "hCr₂N") particle. The first mixed particle group is preferably mixed using a ball mill device, a bead mill device, or the like and is preferably pulverized to have an average particle size of not more than 0.5 µm.

### (Step of Obtaining Second Mixed Particle Group)

Next, in the step (S2) of obtaining the second mixed particle group, the first mixed particle group is thermally treated to obtain the second mixed particle group including a cubic CrN particle.

The thermal treatment can be performed by heating the first mixed particle group in a nitrogen atmosphere at not less than 800°C and not more than 1100°C, for example. Accordingly, hexagonal Cr₂N included in the first mixed particle group is changed into cubic CrN.

### (Step of Obtaining First Particle Group)

Next, in the step (S3) of obtaining the first particle group, the second mixed particle group is treated by the isostatic synthesis method or the impulsive compression method to obtain the first particle group including the cubic AlCrN particle.

The impulsive compression method can be performed, for example, by: mixing the second mixed particle group with copper powder serving as a heat sink and pressure medium; introducing them into a steel container; and momentarily applying a pressure of not less than 15 GPa by way of an impulse wave for a pressure application time of not more than 50 microseconds. Accordingly, the hexagonal AlN included in the second mixed particle group is changed into cubic AlN, and Cr is dissolved in the cubic AlN in the solid state, thus synthesizing cubic AlCrN. For the impulsive application of pressure, a pressure of not less than 15 GPa and not more than 50 GPa is preferable and a pressure of not less than 35 GPa and not more than 50 GPa is more preferable. A temperature during the impulsive application of pressure is preferably not less than 1200°C and not more than 3000°C, and is more preferably not less than 1800°C and not more than 2200°C.

The obtained first particle group is preferably pulverized using a ball mill device, a bead mill device, or the like into an average particle size of not less than 0.1 µm and not more than 0.5 µm.The first particle group can be used as a source material of the sintered material.

### (Step of Obtaining Third Mixed Particle Group)

Next, in the step (S4) of obtaining the third mixed particle group, the third mixed particle group is obtained by mixing the first particle group with a second particle group including a particle of at least one first compound selected from a group consisting of oxide and oxynitride of aluminum.

The third particle group further includes a cubic boron nitride.

The third mixed particle group is preferably mixed using a ball mill device, a bead mill device, or the like, and is preferably pulverized to have an average particle size of not more than 0.5 µm.

### (Step of Obtaining Sintered Material)

Next, in the step (S5) of obtaining the sintered material, the third mixed particle group is sintered to obtain the sintered material.

Specifically, for example, the third mixed particle group can be treated at a pressure of not less than 10 kPa and not more than 15 GPa and at a temperature of not less than 800°C and not more than 1900°C, thereby obtaining the sintered material. The step of obtaining the sintered material is preferably performed under a non-oxidizing atmosphere, particularly, in vacuum or under a nitrogen atmosphere. Although a sintering method is not particularly limited, spark plasma sintering (SPS), hot press, ultra-high pressure press, or the like can be used.

### <Fourth Embodiment>

A method of producing a sintered material according to a fourth embodiment is according to claim 6.

The step of performing the vapor phase synthesis of the thin film including the first particle group can be performed, for example, by treating the target by an arc ion plating method to form the thin film on the substrate. In this case, for example, treatment conditions can be set as follows: an Ar flow rate of 20 sccm; a N₂ flow rate of 80 sccm; a pressure of 2 Pa; a bias of 110 V; an arc current of 91 A; and a substrate temperature of 400°C.

### Example 1

The following describes the present invention more specifically by way of examples. However, the present invention is not limited by these examples.

### [Samples 1 to 42]

Samples 1-22 are not according to the invention.

### (Step of Obtaining First Mixed Particle Group)

Hexagonal AlN particles (provided by Tokuyama Corporation) and hexagonal Cr₂N particles (provided by Shin Nippon Kinzoku Co., Ltd.) were mixed at a ratio of 10:90 to 90:10, thereby obtaining a first mixed particle group. It should be noted that the first mixed particle group was pulverized by a bead mill to have an average particle size of not more than 0.5 µm.

### (Step of Obtaining Second Mixed Particle Group)

Next, the first mixed particle group was thermally treated in a nitrogen treatment furnace at 900°C, thereby obtaining a second mixed particle group including cubic CrN particles. A ratio of a content (mol %) of hAlN to a content (mol %) of cCrN in the second mixed particle group of each sample is shown in Table 1 at the column "Second Mixed Particle Group".

### (Step of Obtaining First Particle Group)

Next, the second mixed particle group was mixed with a heat sink and copper powder, and was introduced into a steel container. Then, by explosion of an explosive, the second mixed particle group was treated at a pressure of 40 GPa and a temperature of 2000°C, thereby obtaining the first particle group. The obtained first particle group was subjected to XRD analysis, and cAlCrN was identified. It should be noted that the first particle group was pulverized by a bead mill to have an average particle size of not more than 0.5 µm.

### (Step of Obtaining Third Mixed Particle Group)

Next, the first particle group, the second particle group, and the third particle group were mixed to obtain a third mixed particle group. It should be noted that respective blending amounts thereof and types of compounds included in each particle group are shown in Table 1. It should be noted that the third mixed particle group was pulverized by a bead mill to have an average particle size of not more than 0.5 µm.

### (Step of Obtaining Sintered Material)

Next, the third mixed particle group was introduced into a capsule composed of tantalum, and was sintered for 15 minutes at a pressure of 7 GPa and a temperature of 1350°C using a pressing machine, thereby obtaining a sintered material.

### (Measurement of Sintered Material)

The sintered material was subjected to XRD analysis and a lattice constant was refined by a Rietveld method, thereby obtaining a lattice constant of cAl₍₁₋ₓ₎CrₓN and a value of x. Here, the value of x was obtained by determining an amount of solid solution of Cr through proportion calculation based on a cAlN lattice constant of 4.12 Å and a cCrN lattice constant of 4.15 Å. The result is shown in Table 1.

When the CP-treated surface of the sintered material was observed with SEM-EDX, it was confirmed that an area ratio of AlCrN to the second particle group in the CP-treated surface of the sintered material was substantially the same as a volume ratio of the first particle group to the second particle group in the third mixed particle group (employed software: WinROOF by Mitani Corporation).

### (Evaluation)

The obtained sintered material was cut by a laser and was finished to produce a cutting tool with a tool shape of CNMA120408 and a negative land of 15° × 0.1 to 0.15 mm. The obtained cutting tool was used for a test of cutting a centrifugal cast iron under below-described cutting conditions to measure an amount (µm) of flank wear after cutting for 1.5 km. Moreover, wear type and chipping state of the cutting tool after cutting for 2.0 km were observed.
Cutting speed: 900 m/minute
Depth of cut: 0.1 mm
Feed rate: 0.28 mm/rev
Coolant: emulsion
Lathe: OKUMA LB400; Holder: EWN68-150CKB6
Workpiece: centrifugal cast iron having a structure of dense perlite and having a chemical composition of gray cast iron
Shape of workpiece: cylindrical shape; inner diameter φ of 85 mm

The result is shown in Table 1.

**[Table 1]**

| Sample No. | Second Mixed Particle Group | | Third Mixed Particle Group | | | | | Sintered Material | | Evaluation | |
|---|---|---|---|---|---|---|---|---|---|---|---|
| | Al (mol%) | Cr (mol%) | First Particle Group | Second Particle Group | | Third Particle Group | | Al Lattice Constant | Value of x of Al(1-x)CrxN | Amount [µm] of Flank Wear after 1.5 km | Wear Type and Chipping State after 2.0 km |
| | | | Blending Amount (vol%) | Type (Volume Ratio) | Blending Amount (vol%) | T ype | Total Blending Amount (vol%) | | | | |
| 1* | 10 | 90 | 99.5 | Al₂O₃ | 0.5 | - | - | 4.147 | 0.9 | 220 | Chipping |
| 2* | 20 | 80 | 99.5 | Al₂O₃ | 0.5 | - | - | 4.144 | 0.8 | 120 | Fine Chipping |
| 3* | 30 | 70 | 99.5 | Al₂O₃ | 0.5 | - | - | 4.141 | 0.7 | 97 | Fine Chipping |
| 4* | 50 | 50 | 99.5 | Al₂O₃ | 0.5 | - | - | 4.135 | 0.5 | 66 | Fine Chipping |
| 5* | 70 | 30 | 99.5 | Al₂O₃ | 0.5 | - | - | 4.129 | 0.3 | 85 | Fine Chipping |
| 6* | 80 | 20 | 99.5 | Al₂O₃ | 0.5 | - | - | 4.126 | 0.2 | 98 | Fine Chipping |
| 7* | 90 | 10 | 99.5 | Al₂O₃ | 0.5 | - | - | 4.123 | 0.1 | 124 | Chipping |
| 8* | 50 | 50 | 95 | Al₂O₃ | 5 | - | - | 4.135 | 0.5 | 65 | Fine Chipping |
| 9* | 50 | 50 | 90 | Al₂O₃ | 10 | - | - | 4.135 | 0.5 | 66 | Fine Chipping |
| 10* | 50 | 50 | 80 | Al₂O₃ | 20 | - | - | 4.135 | 0.5 | 67 | Fine Chipping |
| 11* | 50 | 50 | 70 | Al₂O₃ | 30 | - | - | 4.135 | 0.5 | 67 | Normal Wear |
| 12* | 50 | 50 | 60 | Al₂O₃ | 40 | - | - | 4.135 | 0.5 | 68 | Normal Wear |
| 13* | 50 | 50 | 50 | Al₂O₃ | 50 | - | - | 4.135 | 0.5 | 69 | Normal Wear |
| 14* | 50 | 50 | 40 | Al₂O₃ | 60 | - | - | 4.135 | 0.5 | 71 | Normal Wear |
| 15* | 50 | 50 | 10 | Al₂O₃ | 90 | - | - | 4.135 | 0.5 | 90 | Normal Wear |
| 16* | 50 | 50 | 70 | AlON | 30 | - | - | 4.135 | 0.5 | 75 | Normal Wear |
| 17* | 50 | 50 | 70 | ZrO₂ | 30 | - | - | 4.135 | 0.5 | 70 | Normal Wear |
| 18* | 50 | 50 | 99.5 | MgO | 0.5 | - | - | 4.135 | 0.5 | 67 | Fine Chipping |
| 19* | 50 | 50 | 99.5 | HfO₂ | 0.5 | - | - | 4.135 | 0.5 | 68 | Fine Chipping |
| 20* | 50 | 50 | 99.5 | Y₂O₃ | 0.5 | - | - | 4.135 | 0.5 | 67 | Fine Chipping |
| 21* | 50 | 50 | 90 | Al₂O₃:ZrO₂ (7:3) | 10 | - | - | 4.135 | 0.5 | 69 | Normal Wear |
| 22* | 50 | 50 | 90 | Al₂O₃:ZrO₂ (9:1) | 10 | - | - | 4.135 | 0.5 | 66 | Normal Wear |
| 23 | 50 | 50 | 60 | Al₂O₃:Y₂O₃ (9:1) | 10 | cBN | 30 | 4.135 | 0.5 | 79 | Normal Wear |
| 24 | 50 | 50 | 60 | Al₂O₃:MgO (9:1) | 10 | cBN | 30 | 4.135 | 0.5 | 82 | Normal Wear |
| 25 | 50 | 50 | 60 | Al₂O₃:HfO₂ (9:1) | 10 | cBN | 30 | 4.135 | 0.5 | 83 | Normal Wear |
| 26 | 50 | 50 | 60 | Al₂O₃:ZrO₂:Y₂O₃ (8:1.5:0.5) | 10 | cBN | 30 | 4.135 | 0.5 | 81 | Normal Wear |
| 27 | 50 | 50 | 60 | Al₂O₃:ZrO₂:MgO (8:1.5:0.5) | 10 | cBN | 30 | 4.135 | 0.5 | 85 | Normal Wear |
| 28 | 50 | 50 | 60 | Al₂O₃:ZrO₂:HfO₂ (8:1.5:0.5) | 10 | cBN | 30 | 4.135 | 0.5 | 84 | Normal Wear |
| 29 | 50 | 50 | 60 | AlON:ZrO₂:Y₂O₃ (8:1.5:0.5) | 10 | cBN | 30 | 4.135 | 0.5 | 86 | Normal Wear |
| 30 | 50 | 50 | 80 | Al₂O₃ | 10 | cBN | 10 | 4.135 | 0.5 | 66 | Normal Wear |
| 31 | 50 | 50 | 70 | Al₂O₃ | 10 | cBN | 20 | 4.135 | 0.5 | 68 | Normal Wear |
| 32 | 50 | 50 | 60 | Al₂O₃ | 10 | cBN | 30 | 4.135 | 0.5 | 73 | Normal Wear |
| 33 | 50 | 50 | 50 | Al₂O₃ | 10 | cBN | 40 | 4.135 | 0.5 | 76 | Normal Wear |
| 34 | 50 | 50 | 40 | Al₂O₃ | 10 | cBN | 50 | 4.135 | 0.5 | 135 | Normal Wear |
| 35 | 50 | 50 | 30 | Al₂O₃ | 10 | cBN | 60 | 4.135 | 0.5 | 150 | Normal Wear |
| 36 | 50 | 50 | 20 | Al₂O₃ | 10 | cBN | 70 | 4.135 | 0.5 | 183 | Normal Wear |
| 37 | 50 | 50 | 10 | Al₂O₃ | 10 | cBN | 80 | 4.135 | 0.5 | 220 | Normal Wear |
| 38 | 50 | 50 | 69.5 | Al₂O₃:ZrO₂ (15:5) | 20 | cBN | 30 | 4.135 | 0.5 | 72 | Normal Wear |
| 39 | 50 | 50 | 60 | Al₂O₃:ZrO₂ (19:1) | 20 | cBN | 20 | 4.135 | 0.5 | 68 | Normal Wear |
| 40 | 50 | 50 | 50 | Al₂O₃:ZrO₂ (19:1) | 20 | cBN | 30 | 4.135 | 0.5 | 73 | Normal Wear |
| 41 | 50 | 50 | 40 | Al₂O₃:ZrO₂ (19:1) | 20 | cBN | 40 | 4.135 | 0.5 | 76 | Normal Wear |
| 42 | 50 | 50 | 30 | Al₂O₃:ZrO₂ (19:1) | 20 | cBN | 50 | 4.135 | 0.5 | 135 | Normal Wear |

| | | | | | | | | | | | |
|---|---|---|---|---|---|---|---|---|---|---|---|
| *Reference Examples | | | | | | | | | | | |

### (Evaluation Result)

In comparison among sample 1 to sample 7, when the value of x in the formula (1) above was not less than 0.2 and not more than 0.8 (samples 2 to 6), the wear resistance of each of the sintered materials was excellent.

In comparison among sample 8 to sample 14, as the amount of the first particle group in the third mixed particle group was larger, the wear resistance of each of the sintered materials was more excellent.

In comparison among sample 4 and samples 15 to 20, the wear resistances of the sintered materials were equally excellent when Al₂O₃, ZrO₂, Y₂O₃, MgO, or HfO₂ was used as the second particle group.

In comparison among sample 4 and samples 21 to 29, the chipping resistance was excellent when particles of two or more compounds were used as a second particle group. Moreover, the chipping resistance was also excellent when cBN was used as the third particle group.

In comparison among samples 30 to 37, each of the samples was excellent in chipping resistance, and the wear resistance was more excellent as the amount of the third particle group in the third mixed particle group was smaller.

### Example 2

### [Samples 43 to 84]

Samples 43-64 are not according to the invention.

### (Step of Obtaining First Mixed Particle Group)

Hexagonal AlN particles (provided by Tokuyama Corporation) and hexagonal Cr₂N particles (provided by Shin Nippon Kinzoku Co., Ltd.) were mixed to attain an atomic ratio of Al to Cr as shown in Table 2 at the column "Blending Ratio", thereby obtaining a first mixed particle group. It should be noted that the first mixed particle group was pulverized by a bead mill to have an average particle size of not more than 0.5 µm.

### (Step of Obtaining First Particle Group)

Next, the first mixed particle group was treated in a nitrogen furnace at a nitrogen pressure of 8 MPa and a temperature of 2000°C, thereby producing a first particle group (isostatic synthesis method). The particle hard material was subjected to XRD analysis, and cAlCrN was identified.

### (Step of Obtaining Third Mixed Particle Group)

Next, the first particle group, the second particle group, and the third particle group were mixed to obtain a third mixed particle group. It should be noted that respective blending amounts thereof and types of compounds included in each particle group are shown in Table 2. It should be noted that the third mixed particle group was pulverized by a bead mill to have an average particle size of not more than 0.5 µm.

### (Step of Obtaining Sintered Material)

Next, the third mixed particle group was introduced into a capsule composed of tantalum, and was sintered for 15 minutes at a pressure of 7 GPa and a temperature of 1350°C using a pressing machine, thereby obtaining a sintered material.

### (Measurement of Sintered Material)

The sintered material was subjected to XRD analysis and a lattice constant was refined by a Rietveld method, thereby obtaining a lattice constant of cAl₍₁₋ₓ₎CrₓN and a value of x. Here, the value of x was obtained by determining an amount of solid solution of Cr through proportion calculation based on a cAlN lattice constant of 4.12 Å and a cCrN lattice constant of 4.15 Å. The result is shown in Table 2.

When the CP-treated surface of the sintered material was observed with SEM-EDX, it was confirmed that an area ratio of AlCrN to the second particle group in the CP-treated surface of the sintered material was substantially the same as a volume ratio of the first particle group to the second particle group in the third mixed particle group (employed software: WinROOF by Mitani Corporation).

### (Evaluation)

The obtained sintered material was cut by a laser and was finished to produce a cutting tool with a tool shape of CNMA120408 and a negative land of 15° × 0.1 to 0.15 mm. The obtained cutting tool was used for a test of cutting a centrifugal cast iron under below-described cutting conditions to measure an amount (µm) of flank wear after cutting for 1.5 km. Moreover, wear type and chipping state of the cutting tool after cutting for 2.0 km were observed.
Cutting speed: 900 m/minute
Depth of cut: 0.1 mm
Feed rate: 0.28 mm/rev
Coolant: emulsion
Lathe: OKUMA LB400; Holder: EWN68-150CKB6
Workpiece: centrifugal cast iron having a structure of dense perlite and having a chemical composition of gray cast iron
Shape of workpiece: cylindrical shape; inner diameter φ of 85 mm

The result is shown in Table 2.

**[Table 2]**

| Sample No. | Blending Ratio | | Third Mixed Particle Group | | | | | Sintered Material | | Evaluation | |
|---|---|---|---|---|---|---|---|---|---|---|---|
| | Al (at%) | Cr (at%) | First Particle Group | Second Particle Group | | Third Particle Group | | Al Lattice Constant | Value of x of Al(1-x)CrxN | Amount [µm] of Flank Wear after 1.5 km | Wear Type and Chipping State after 2.0 km |
| | | | Blending Amount (vol%) | Type (Volume Ratio) | Blending Amount (vol%) | Type | Total Blending Amount (vol%) | | | | |
| 43 * | 10 | 90 | 99.5 | Al₂O₃ | 0.5 | - | - | 4.147 | 0.9 | 220 | Chipping |
| 44 * | 20 | 80 | 99.5 | Al₂O₃ | 0.5 | - | - | 4.144 | 0.8 | 120 | Fine Chipping |
| 45* | 30 | 70 | 99.5 | Al₂O₃ | 0.5 | - | - | 4.141 | 0.7 | 97 | Fine Chipping |
| 46 * | 50 | 50 | 99.5 | Al₂O₃ | 0.5 | - | - | 4.135 | 0.5 | 66 | Fine Chipping |
| 47* | 70 | 30 | 99.5 | Al₂O₃ | 0.5 | - | - | 4.129 | 0.3 | 85 | Fine Chipping |
| 48 * | 80 | 20 | 99.5 | Al₂O₃ | 0.5 | - | - | 4.126 | 0.2 | 98 | Fine Chipping |
| 49 * | 90 | 10 | 99.5 | Al₂O₃ | 0.5 | - | - | 4.123 | 0.1 | 124 | Chipping |
| 50 * | 50 | 50 | 95 | Al₂O₃ | 5 | - | - | 4.135 | 0.5 | 65 | Fine Chipping |
| 51* | 50 | 50 | 90 | Al₂O₃ | 10 | - | - | 4.135 | 0.5 | 66 | Fine Chipping |
| 52* | 50 | 50 | 80 | Al₂O₃ | 20 | - | - | 4.135 | 0.5 | 67 | Fine Chipping |
| 53* | 50 | 50 | 70 | Al₂O₃ | 30 | - | - | 4.135 | 0.5 | 67 | Normal Wear |
| 54* | 50 | 50 | 60 | Al₂O₃ | 40 | - | - | 4.135 | 0.5 | 68 | Normal Wear |
| 55* | 50 | 50 | 50 | Al₂O₃ | 50 | - | - | 4.135 | 0.5 | 69 | Normal Wear |
| 56 * | 50 | 50 | 40 | Al₂O₃ | 60 | - | - | 4.135 | 0.5 | 71 | Normal Wear |
| 57* | 50 | 50 | 10 | Al₂O₃ | 90 | - | - | 4.135 | 0.5 | 90 | Normal Wear |
| 58 * | 50 | 50 | 70 | AlON | 30 | - | - | 4.135 | 0.5 | 75 | Normal Wear |
| 59 * | 50 | 50 | 70 | ZrO₂ | 30 | - | - | 4.135 | 0.5 | 70 | Normal Wear |
| 60 * | 50 | 50 | 99.5 | MgO | 0.5 | - | - | 4.135 | 0.5 | 67 | Fine Chipping |
| 61* | 50 | 50 | 99.5 | HfO₂ | 0.5 | - | - | 4.135 | 0.5 | 68 | Fine Chipping |
| 62 * | 50 | 50 | 99.5 | Y₂O₃ | 0.5 | - | - | 4.135 | 0.5 | 67 | Fine Chipping |
| 63 * | 50 | 50 | 90 | Al₂O₃:ZrO₂ (7:3) | 10 | - | - | 4.135 | 0.5 | 69 | Normal Wear |
| 64 * | 50 | 50 | 90 | Al₂O₃:ZrO₂ (9:1) | 10 | - | - | 4.135 | 0.5 | 66 | Normal Wear |
| 65 | 50 | 50 | 60 | Al₂O₃:Y₂O₃ (9:1) | 10 | cBN | 30 | 4.135 | 0.5 | 79 | Normal Wear |
| 66 | 50 | 50 | 60 | Al₂O₃:MgO (9:1) | 10 | cBN | 30 | 4.135 | 0.5 | 82 | Normal Wear |
| 67 | 50 | 50 | 60 | Al₂O₃:HfO₂ (9:1) | 10 | cBN | 30 | 4.135 | 0.5 | 83 | Normal Wear |
| 68 | 50 | 50 | 60 | Al₂O₃:ZrO₂:Y₂O₃ (8:1.5:0.5) | 10 | cBN | 30 | 4.135 | 0.5 | 81 | Normal Wear |
| 69 | 50 | 50 | 60 | Al₂O₃:ZrO₂:MgO (8:1.5:0.5) | 10 | cBN | 30 | 4.135 | 0.5 | 85 | Normal Wear |
| 70 | 50 | 50 | 60 | Al₂O₃:ZrO₂:HfO₂ (8:1.5:0.5) | 10 | cBN | 30 | 4.135 | 0.5 | 84 | Normal Wear |
| 71 | 50 | 50 | 60 | AlON:ZrO₂:Y₂O₃ (8:1.5:0.5) | 10 | cBN | 30 | 4.135 | 0.5 | 86 | Normal Wear |
| 72 | 50 | 50 | 80 | Al₂O₃ | 10 | cBN | 10 | 4.135 | 0.5 | 66 | Normal Wear |
| 73 | 50 | 50 | 70 | Al₂O₃ | 10 | cBN | 20 | 4.135 | 0.5 | 68 | Normal Wear |
| 74 | 50 | 50 | 60 | Al₂O₃ | 10 | cBN | 30 | 4.135 | 0.5 | 73 | Normal Wear |
| 75 | 50 | 50 | 50 | Al₂O₃ | 10 | cBN | 40 | 4.135 | 0.5 | 76 | Normal Wear |
| 76 | 50 | 50 | 40 | Al₂O₃ | 10 | cBN | 50 | 4.135 | 0.5 | 135 | Normal Wear |
| 77 | 50 | 50 | 30 | Al₂O₃ | 10 | cBN | 60 | 4.135 | 0.5 | 150 | Normal Wear |
| 78 | 50 | 50 | 20 | Al₂O₃ | 10 | cBN | 70 | 4.135 | 0.5 | 183 | Normal Wear |
| 79 | 50 | 50 | 10 | Al₂O₃ | 10 | cBN | 80 | 4.135 | 0.5 | 220 | Normal Wear |
| 80 | 50 | 50 | 69.5 | Al₂O₃:ZrO₂ (15:5) | 20 | cBN | 30 | 4.135 | 0.5 | 72 | Normal Wear |
| 81 | 50 | 50 | 60 | Al₂O₃:ZrO₂ (19:1) | 20 | cBN | 20 | 4.135 | 0.5 | 68 | Normal Wear |
| 82 | 50 | 50 | 50 | Al₂O₃:ZrO₂ (19:1) | 20 | cBN | 30 | 4.135 | 0.5 | 73 | Normal Wear |
| 83 | 50 | 50 | 40 | Al₂O₃:ZrO₂ (19:1) | 20 | cBN | 40 | 4.135 | 0.5 | 76 | Normal Wear |
| 84 | 50 | 50 | 30 | Al₂O₃:ZrO₂ (19:1) | 20 | cBN | 50 | 4.135 | 0.5 | 135 | Normal Wear |

| | | | | | | | | | | | |
|---|---|---|---|---|---|---|---|---|---|---|---|
| *Reference Example | | | | | | | | | | | |

### (Evaluation Result)

In comparison among sample 43 to sample 49, when the value of x in the formula (1) above was not less than 0.2 and not more than 0.8 (samples 44 to 48), the wear resistance of each of the sintered materials was excellent.

In comparison among sample 50 to sample 56, as the amount of the first particle group in the third mixed particle group was larger, the wear resistance of each of the sintered materials was more excellent.

In comparison among sample 46 and samples 57 to 62, the wear resistances of the sintered materials were equally excellent when Al₂O₃, ZrO₂, Y₂O₃, MgO, or HfO₂ was used as the second particle group.

In comparison among sample 46 and samples 63 to 71, the chipping resistance was excellent when particles of two or more compounds were used as a second particle group. Moreover, the chipping resistance was also excellent when cBN was used as the third particle group.

In comparison among samples 72 to 79, each of the samples was excellent in chipping resistance, and the wear resistance was more excellent as the amount of the third particle group in the third mixed particle group was smaller.

From above, it was confirmed that the sintered material produced using the isostatic synthesis method exhibits a result similar to that of the sintered material produced using the impulsive compression method.

### Example 3

### [Samples 85 to 126]

Samples 85-106 are not according to the invention.

### (Target Preparing Step)

A target was prepared such that a blending ratio (atomic ratio) of Al to Cr in the target was as described in Table 3 at the column "Target Composition".

### (Step of Obtaining First Particle Group)

Next, the target was treated by an arc ion plating method, thereby forming a thin film on a high-speed steel substrate. The treatment conditions were as follows: an Ar flow rate of 20 sccm; a N₂ flow rate of 80 sccm; a pressure of 2 Pa; a bias of 110 V; an arc current of 91 A; and a substrate temperature of 400°C. Next, the thin film formed on the high-speed steel substrate was collected by detaching it from the substrate, and was pulverized by a bead mill into a particle size of 0.5 µm to 3 µm to produce a slurry. Then, the slurry is dried to obtain a first particle group. This first particle group was subjected to XRD analysis, and cAlCrN was identified.

### (Step of Obtaining Third Mixed Particle Group)

Next, the first particle group, the second particle group, and the third particle group were mixed to obtain a third mixed particle group. It should be noted that respective blending amounts thereof and types of compounds included in each particle group are shown in Table 3. It should be noted that the third mixed particle group was pulverized by a bead mill to have an average particle size of not more than 0.5 µm.

### (Step of Obtaining Sintered Material)

Next, the third mixed particle group was introduced into a capsule composed of tantalum, and was sintered for 15 minutes at a pressure of 7 GPa and a temperature of 1350°C using a pressing machine, thereby obtaining a sintered material.

### (Measurement of Sintered Material)

The sintered material was subjected to XRD analysis and a lattice constant was refined by a Rietveld method, thereby obtaining a lattice constant of cAl₍₁₋ₓ)CrₓN and a value of x. Here, the value of x was obtained by determining an amount of solid solution of Cr through proportion calculation based on a cAlN lattice constant of 4.12 Å and a cCrN lattice constant of 4.15 Å. The result is shown in Table 3.

When the CP-treated surface of the sintered material was observed with SEM-EDX, it was confirmed that an area ratio of AlCrN to the second particle group in the CP-treated surface of the sintered material was substantially the same as a volume ratio of the first particle group to the second particle group in the third mixed particle group (employed software: WinROOF by Mitani Corporation).

### (Evaluation)

The obtained sintered material was cut by a laser and was finished to produce a cutting tool with a tool shape of CNMA120408 and a negative land of 15° × 0.1 to 0.15 mm. The obtained cutting tool was used for a test of cutting a centrifugal cast iron under below-described cutting conditions to measure an amount (µm) of flank wear after cutting for 1.5 km. Moreover, wear type and chipping state of the cutting tool after cutting for 2.0 km were observed.
Cutting speed: 900 m/minute
Depth of cut: 0.1 mm
Feed rate: 0.28 mm/rev
Coolant: emulsion
Lathe: OKUMA LB400; Holder: EWN68-150CKB6
Workpiece: centrifugal cast iron having a structure of dense perlite and having a chemical composition of gray cast iron
Shape of workpiece: cylindrical shape; inner diameter φ of 85 mm

The result is shown in Table 3.

**[Table 3]**

| Sample No. | Target Composition | | Third Mixed Particle Group | | | | | Sintered Material | | Evaluation | |
|---|---|---|---|---|---|---|---|---|---|---|---|
| | Al (mol%) | Cr (mol%) | First Particle Group | Second Particle Group | | Third Particle Group | | Al Lattice Constant | Value of x of Al(1-x)CrxN | Amount [µm] of Flank Wear after 1.5 km | Wear Type and Chipping State after 2.0 km |
| | | | Blending Amount (vol%) | Type (Volume Ratio) | Blending Amount (vol%) | Type | Total Blending Amount (vol%) | | | | |
| 85* | 10 | 90 | 99.5 | Al₂O₃ | 0.5 | - | - | 4.147 | 0.9 | 220 | Chipping |
| 86* | 20 | 80 | 99.5 | Al₂O₃ | 0.5 | - | - | 4.144 | 0.8 | 120 | Fine Chipping |
| 87* | 30 | 70 | 99.5 | Al₂O₃ | 0.5 | - | - | 4.141 | 0.7 | 97 | Fine Chipping |
| 88* | 50 | 50 | 99.5 | Al₂O₃ | 0.5 | - | - | 4.135 | 0.5 | 66 | Fine Chipping |
| 89* | 70 | 30 | 99.5 | Al₂O₃ | 0.5 | - | - | 4.129 | 0.3 | 85 | Fine Chipping |
| 90* | 80 | 20 | 99.5 | Al₂O₃ | 0.5 | - | - | 4.126 | 0.2 | 98 | Fine Chipping |
| 91* | 90 | 10 | 99.5 | Al₂O₃ | 0.5 | - | - | 4.123 | 0.1 | 124 | Chipping |
| 92* | 50 | 50 | 95 | Al₂O₃ | 5 | - | - | 4.135 | 0.5 | 65 | Fine Chipping |
| 93* | 50 | 50 | 90 | Al₂O₃ | 10 | - | - | 4.135 | 0.5 | 66 | Fine Chipping |
| 94* | 50 | 50 | 80 | Al₂O₃ | 20 | - | - | 4.135 | 0.5 | 67 | Fine Chipping |
| 95* | 50 | 50 | 70 | Al₂O₃ | 30 | - | - | 4.135 | 0.5 | 67 | Normal Wear |
| 96* | 50 | 50 | 60 | Al₂O₃ | 40 | - | - | 4.135 | 0.5 | 68 | Normal Wear |
| 97* | 50 | 50 | 50 | Al₂O₃ | 50 | - | - | 4.135 | 0.5 | 69 | Normal Wear |
| 98* | 50 | 50 | 40 | Al₂O₃ | 60 | - | - | 4.135 | 0.5 | 71 | Normal Wear |
| 99* | 50 | 50 | 10 | Al₂O₃ | 90 | - | - | 4.135 | 0.5 | 90 | Normal Wear |
| 100* | 50 | 50 | 70 | AlON | 30 | - | - | 4.135 | 0.5 | 75 | Normal Wear |
| 101* | 50 | 50 | 70 | ZrO2 | 30 | - | - | 4.135 | 0.5 | 70 | Normal Wear |
| 102* | 50 | 50 | 99.5 | MgO | 0.5 | - | - | 4.135 | 0.5 | 67 | Fine Chipping |
| 103* | 50 | 50 | 99.5 | HfO₂ | 0.5 | - | - | 4.135 | 0.5 | 68 | Fine Chipping |
| 104* | 50 | 50 | 99.5 | Y₂O₃ | 0.5 | - | - | 4.135 | 0.5 | 67 | Fine Chipping |
| 105* | 50 | 50 | 90 | Al₂O₃:ZrO₂ (7:3) | 10 | - | - | 4.135 | 0.5 | 69 | Normal Wear |
| 106* | 50 | 50 | 90 | Al₂O₃:ZrO₂ (9:1) | 10 | - | - | 4.135 | 0.5 | 66 | Normal Wear |
| 107 | 50 | 50 | 60 | Al₂O₃:Y₂O₃ (9:1) | 10 | cBN | 30 | 4.135 | 0.5 | 79 | Normal Wear |
| 108 | 50 | 50 | 60 | Al₂O₃:MgO (9:1) | 10 | cBN | 30 | 4.135 | 0.5 | 82 | Normal Wear |
| 109 | 50 | 50 | 60 | Al₂O₃:HfO₂ (9:1) | 10 | cBN | 30 | 4.135 | 0.5 | 83 | Normal Wear |
| 110 | 50 | 50 | 60 | Al₂O₃:ZrO₂:Y₂O₃ (8:1.5:0.5) | 10 | cBN | 30 | 4.135 | 0.5 | 81 | Normal Wear |
| 111 | 50 | 50 | 60 | Al₂O₃:ZrO₂:MgO (8:1.5:0.5) | 10 | cBN | 30 | 4.135 | 0.5 | 85 | Normal Wear |
| 112 | 50 | 50 | 60 | Al₂O₃:ZrO₂:HfO₂ (8:1.5:0.5) | 10 | cBN | 30 | 4.135 | 0.5 | 84 | Normal Wear |
| 113 | 50 | 50 | 60 | AlON:ZrO₂:Y₂O₃ (8:1.5:0.5) | 10 | cBN | 30 | 4.135 | 0.5 | 86 | Normal Wear |
| 114 | 50 | 50 | 80 | Al₂O₃ | 10 | cBN | 10 | 4.135 | 0.5 | 66 | Normal Wear |
| 115 | 50 | 50 | 70 | Al₂O₃ | 10 | cBN | 20 | 4.135 | 0.5 | 68 | Normal Wear |
| 116 | 50 | 50 | 60 | Al₂O₃ | 10 | cBN | 30 | 4.135 | 0.5 | 73 | Normal Wear |
| 117 | 50 | 50 | 50 | Al₂O₃ | 10 | cBN | 40 | 4.135 | 0.5 | 76 | Normal Wear |
| 118 | 50 | 50 | 40 | Al₂O₃ | 10 | cBN | 50 | 4.135 | 0.5 | 135 | Normal Wear |
| 119 | 50 | 50 | 30 | Al₂O₃ | 10 | cBN | 60 | 4.135 | 0.5 | 150 | Normal Wear |
| 120 | 50 | 50 | 20 | Al₂O₃ | 10 | cBN | 70 | 4.135 | 0.5 | 183 | Normal Wear |
| 121 | 50 | 50 | 10 | Al₂O₃ | 10 | cBN | 80 | 4.135 | 0.5 | 220 | Normal Wear |
| 122 | 50 | 50 | 69.5 | Al₂O₃:ZrO₂ (15:5) | 20 | cBN | 30 | 4.135 | 0.5 | 72 | Normal Wear |
| 123 | 50 | 50 | 60 | Al₂O₃:ZrO₂ (19:1) | 20 | cBN | 20 | 4.135 | 0.5 | 68 | Normal Wear |
| 124 | 50 | 50 | 50 | Al₂O₃:ZrO₂ (19:1) | 20 | cBN | 30 | 4.135 | 0.5 | 73 | Normal Wear |
| 125 | 50 | 50 | 40 | Al₂O₃:ZrO₂ (19:1) | 20 | cBN | 40 | 4.135 | 0.5 | 76 | Normal Wear |
| 126 | 50 | 50 | 30 | Al₂O₃:ZrO₂ (19:1) | 20 | cBN | 50 | 4.135 | 0.5 | 135 | Normal Wear |

| | | | | | | | | | | | |
|---|---|---|---|---|---|---|---|---|---|---|---|
| *Reference Examples | | | | | | | | | | | |

### (Evaluation Result)

In comparison among sample 85 to sample 91, when the value of x in the formula (1) above was not less than 0.2 and not more than 0.8 (samples 2 to 6), the wear resistance of each of the sintered materials was excellent.

In comparison among sample 92 to sample 98, as the amount of the first particle group in the third mixed particle group was larger, the wear resistance of each of the sintered materials was more excellent.

In comparison among sample 88 and samples 99 to 104, the wear resistances of the sintered materials were equally excellent when Al₂O₃, ZrO₂, Y₂O₃, MgO, or HfO₂ was used as the second particle group.

In comparison among sample 88 and samples 105 to 113, the chipping resistance was excellent when particles of two or more compounds were used as a second particle group. Moreover, the chipping resistance was also excellent when cBN was used as the third particle group.

In comparison among samples 114 to 121, each of the samples was excellent in chipping resistance, and the wear resistance was more excellent as the amount of the third particle group in the third mixed particle group was smaller.

From above, it was confirmed that the sintered material produced using the physical vapor deposition method exhibits a result similar to that of the sintered material produced using the impulsive compression method.

The embodiments and examples disclosed herein are illustrative and non-restrictive in any respect.

### INDUSTRIAL APPLICABILITY

The sintered material including cubic AlCrN according to one embodiment of the present invention can be widely used for cutting tools. For example, the sintered material can be used for a drill, an end mill, an indexable cutting insert for milling, an indexable cutting insert for turning, a metal saw, a gear cutting tool, a reamer, or a tap

## Claims

1. A sintered material comprising:
a first particle group including a particle having a cubic rock-salt structure represented by Al₁₋ₓCrₓN (formula (1)), where x satisfies 0.3 ≤ x ≤ 0.7; and
a second particle group including a particle of at least one first compound selected from a group consisting of oxide and oxynitride of aluminum; and
a third particle group including a cubic boron nitride.

2. The sintered material according to claim 1, wherein
the sintered material includes not less than 0.5 volume % and not more than 90 volume % of the second particle group, and
the first compound includes at least one selected from a group consisting of Al₂O₃ and AlON.

3. The sintered material according to claim 1 or claim 2, wherein the sintered material includes not less than 20 volume % and not more than 70 volume % of the third particle group.

4. A cutting tool comprising the sintered material recited in any one of claim 1 to claim 3.

5. A method of producing the sintered material recited in any one of claim 1 to claim 3, the method comprising:
obtaining a first mixed particle group including a hexagonal AlN particle and a hexagonal Cr₂N particle;
obtaining a second mixed particle group including a cubic CrN particle by thermally treating the first mixed particle group;
obtaining, by treating the second mixed particle group through an isostatic synthesis method or an impulsive compression method, a first particle group including a particle having a cubic rock-salt structure represented by Al₁₋ₓCrₓN (formula (1)), where x satisfies 0.3 ≤ x ≤ 0.7;
obtaining a third mixed particle group by mixing the first particle group with a second particle group including a particle of at least one first compound selected from a group consisting of oxide and oxynitride of aluminum, wherein the third mixed particle group includes a cubic boron nitride; and
obtaining a sintered material by sintering the third mixed particle group.

6. A method of producing the sintered material recited in any one of claim 1 to claim 3, the method comprising:
preparing a target including aluminum and chromium as component elements;
performing vapor phase synthesis of a thin film on a substrate by treating the target through a physical vapor deposition method in an argon and nitrogen atmosphere, the thin film including a first particle group including a particle having a cubic rock-salt structure represented by Al₁₋ₓCrₓN (formula (1)), where x satisfies 0.3 ≤ x ≤ 0.7;
obtaining a third mixed particle group by mixing the thin film including the first particle group with a second particle group including a particle of at least one first compound selected from a group consisting of oxide and oxynitride of aluminum, wherein the third mixed particle group includes a cubic boron nitride; and
obtaining a sintered material by sintering the third mixed particle group.

## Patentansprüche

1. Gesintertes Material, umfassend:
eine erste Partikelgruppe, die ein Partikel enthält, das eine kubische Steinsalzstruktur aufweist, welche durch Al₁₋ₓCrₓN (Formel (1)) repräsentiert ist, wobei x 0,3 ≤ x ≤ 0,7 erfüllt; und
eine zweite Partikelgruppe, die ein Partikel zumindest einer ersten Verbindung enthält, die ausgewählt ist aus einer Gruppe, die aus Oxid und Oxinitrid von Aluminium besteht; und
eine dritte Partikelgruppe, die ein kubisches Bornitrid enthält.

2. Gesintertes Material gemäß Anspruch 1, wobei
das gesinterte Material nicht weniger als 0,5 Vol.-% und nicht mehr als 90 Vol.-% der zweiten Partikelgruppe enthält, und
die erste Verbindung zumindest eine beinhaltet, die ausgewählt ist aus der Gruppe, die aus Al₂O₃ und AlON besteht.

3. Gesintertes Material gemäß Anspruch 1 oder Anspruch 2, wobei das gesinterte Material nicht weniger als 20 Vol.-% und nicht mehr als 70 Vol.-% der dritten Partikelgruppe enthält.

4. Schneidwerkzeug, das ein gesintertes Material gemäß einem der Ansprüche 1 bis 3 umfasst.

5. Verfahren der Herstellung eines gesinterten Materials gemäß einem der Ansprüche 1 bis 3, wobei das Verfahren umfasst:
Erhalten einer ersten gemischten Partikelgruppe, die ein hexagonalen AlN-Partikel und ein hexagonales Cr₂N-Partikel beinhaltet;
Erhalten einer zweiten gemischten Partikelgruppe, die ein kubisches CrN-Partikel beinhaltet, durch thermisches Behandeln der ersten gemischten Partikelgruppe;
Erhalten, durch Behandeln der zweiten gemischten Partikelgruppe durch ein isostatisches Syntheseverfahren oder ein Impulsiv-Kompressionsverfahren, einer ersten Partikelgruppe, die ein Partikel beinhaltet, das eine kubische Steinsalzstruktur aufweist, die durch Al₁₋ₓCrₓN (Formel (1)) repräsentiert ist, wobei x 0,3 ≤ x ≤ 0,7 erfüllt;
Erhalten einer dritten gemischten Partikelgruppe durch Mischen der ersten Partikelgruppe mit einer zweiten Partikelgruppe, die ein Partikel zumindest einer ersten Verbindung beinhaltet, die ausgewählt ist aus einer Gruppe, die aus Oxid und Oxinitrid von Aluminium besteht, wobei die dritte gemischte Partikelgruppe ein kubisches Bornitrid beinhaltet; und
Erhalten eines gesinterten Materials durch Sintern der dritten gemischten Partikelgruppe.

6. Verfahren der Herstellung des gesinterten Materials gemäß einem von Ansprüchen 1 bis 3, wobei das Verfahren umfasst:
Vorbereiten eines Ziels, das Aluminium und Chrom als Komponentenelemente enthält;
Durchführen von Dampfphasen-Synthese eines Dünnfilms auf einem Substrat durch Behandeln des Ziels durch ein physikalisches Dampfabscheidungsverfahren in einer Argon- und Stickstoff-Atmosphäre, wobei der Dünnfilm eine erste Partikelgruppe beinhaltet, die ein Partikel beinhaltet, das eine kubische Steinsalzstruktur aufweist, DAS durch Al₁₋ₓCrₓN (Formel (1)) repräsentiert ist, wobei x 0,3 ≤ x ≤ 0,7 erfüllt;
Erhalten einer dritten gemischten Partikelgruppe durch Mischen des Dünnfilms, der die erste Partikelgruppe enthält, mit einer zweiten Partikelgruppe, die ein Partikel zumindest einer ersten Verbindung beinhaltet, die ausgewählt ist aus einer Gruppe, die aus Oxid und Oxinitrid von Aluminium besteht, wobei die dritte gemischte Partikelgruppe ein kubisches Bornitrid beinhaltet; und
Erhalten eines gesinterten Materials durch Sintern der dritten gemischten Partikelgruppe.

## Revendications

1. Matériau fritté comprenant :
un premier groupe de particule incluant une particule présentant une structure de sel gemme cubique représentée par Al₁₋ₓCrₓN (formule (1)), où x satisfait 0,3 ≤ x ≤ 0,7 ; et
un second groupe de particule incluant une particule d'au moins un premier composé choisi dans un groupe consistant en oxyde et oxynitrure d'aluminium ; et
un troisième groupe de particule incluant un nitrure de bore cubique.

2. Matériau fritté selon la revendication 1, dans lequel
le matériau fritté inclut au moins 0,5 % en volume et au plus 90 % en volume du second groupe de particule, et
le premier composé inclut au moins un choisi dans un groupe consistant en Al₂O₃ et AlON.

3. Matériau fritté selon la revendication 1 ou la revendication 2, dans lequel le matériau fritté inclut au moins 20 % en volume et au plus 70 % en volume du troisième groupe de particule.

4. Outil de coupe comprenant le matériau fritté cité dans l'une quelconque de la revendication 1 à la revendication 3.

5. Procédé de production du matériau fritté selon l'une quelconque de la revendication 1 à la revendication 3, le procédé comprenant :
l'obtention d'un premier groupe de particule mixte incluant une particule d'AlN hexagonale et une particule de Cr₂N hexagonale ;
l'obtention d'un second groupe de particule mixte incluant une particule de CrN cubique par traitement thermique du premier groupe de particule mixte ;
l'obtention, par traitement du second groupe de particule mixte par un procédé de synthèse isostatique ou un procédé de compression impulsive, d'un premier groupe de particule incluant une particule présentant une structure de sel gemme cubique représentée par Al₁₋ₓCrₓN (formule (1)), où x satisfait 0,3 ≤ x ≤ 0,7 ;
l'obtention d'un troisième groupe de particule mixte en mélangeant le premier groupe de particule avec un second groupe de particule incluant une particule d'au moins un premier composé choisi dans un groupe consistant en oxyde et oxynitrure d'aluminium, dans lequel le troisième groupe de particule mixte inclut un nitrure de bore cubique ; et
l'obtention d'un matériau fritté par frittage du troisième groupe de particule mixte.

6. Procédé de production du matériau fritté selon l'une quelconque de la revendication 1 à la revendication 3, le procédé comprenant :
la préparation d'une cible incluant de l'aluminium et du chrome comme éléments de constituants ;
la réalisation d'une synthèse en phase vapeur d'un mince film sur un substrat par traitement de la cible par un procédé de dépôt physique en phase vapeur dans une atmosphère d'argon et d'azote, le mince film incluant un premier groupe de particule incluant une particule présentant une structure de sel gemme cubique représentée par Al₁₋ₓCrₓN (formule (1)), où x satisfait 0,3 ≤ x ≤ 0,7 ;
l'obtention d'un troisième groupe de particule mixte par mélange du mince film incluant le premier groupe de particule avec un second groupe de particule incluant une particule d'au moins un premier composé choisi dans un groupe consistant en oxyde et oxynitrure d'aluminium, dans lequel le troisième groupe de particule mixte inclut un nitrure de bore cubique ; et
l'obtention d'un matériau fritté par frittage du troisième groupe de particule mixte.
